# EUROPÄISCHE PATENTSCHRIFT

(11) **EP 1 716 629 B1**
(45) Veröffentlichungstag und Bekanntmachung des Hinweises auf die Patenterteilung: **22.09.2010**
(21) Anmeldenummer: 05706186.3
(22) Anmeldetag: 10.02.2005
(51) Int. Cl.: H02M 5/45, H02J 3/32

(54) **EINRICHTUNG ZUR SPITZENLAST-ABDECKUNG**
DEVICE FOR COVERING THE PEAK LOAD
DISPOSITIF POUR COUVRIR LA CHARGE MAXIMALE

(30) Priorität: 19.02.2004 AT 2722004
(43) Veröffentlichungstag der Anmeldung: 02.11.2006
(73) Patentinhaber: Siemens Aktiengesellschaft, 80333 München (DE)
(72) Erfinder: SCHWEIGERT, Harald, A-1120 Wien (AT); APPEL, Wilhelm, A-2136 Laa/Thaya (AT)
(74) Vertreter: Maier, Daniel Oliver
(86) Internationale Anmeldenummer: PCT/AT2005/000045
(87) Internationale Veröffentlichungsnummer: WO 2005/081388

(56) Entgegenhaltungen:
- EP-A- 1 122 856
- US-A- 5 182 463
- US-A- 5 500 561

## Beschreibung

Die Erfindung betrifft eine Einrichtung zur Spitzenlastabdeckung eines an einen Wechselstromanschluss eines öffentlichen Elektrizitätsnetzes anschließbaren elektrischen Verbrauchers, mit einem Wechselrichter, der aus einem Gleichstromspeicher speisbar und mit seinem Ausgang an die Elektrizitätsversorgung des Verbrauchers parallel anschließbar ist, einer in den Anschlusskreis des Verbrauchers schaltbare Messeinrichtung und einer Steuereinrichtung, die dazu eingerichtet ist, mithilfe der Messeinrichtung den Energieverbrauch des Verbrauchers zu überwachen und im Falle eines Anstiegs des so erhaltenen Energieverbrauchswertes über einen vorgegebenen Schwellenwert den Wechselrichter zur Unterstützung der Versorgung des Verbrauchers in Betrieb zu nehmen.

Eine Einrichtung dieser Art ist in der JP 2003-244840 A beschrieben. Zur Überbrückung von Verbrauchsspitzen wird in einer Systemsteuerung ein gemittelter Energieverbrauch des Verbrauchers berechnet, und wenn dieser Mittelwert einen vorgegebenen Wert überschreitet, wird eine Gleichstromversorgung über einen Gleichstrom-Wechselstroron-Konverter hinzugeschaltet. Die JP 2003-259566 A offenbart eine ähnliche Wechselstromversorgung.

Die US 5,500,561 A und die US 2002/0186576 A1 beschreiben Versorgungen von Gleichstromlasten, bei denen ein Lastausgleich mittels Gleichsstrom-Hilfsspeichem erfolgt.

Stromgesellschaften haben oftmals, insbesondere im Gewerbebereich, Tarifmodelle, die nicht nur nach dem Gesamtverbrauch (gemessen z.B. in kWh), sondern auch nach den Verbrauchsspitzen ausgerichtet sind, also nach dem Maximalwert eines (integrierten) temporären Verbrauchs (ebenfalls in kWh gemessen, da jeweils auf ein kurzes Zeitintervall bezogen). Hierbei wird der Stromverbrauch über eine vorgegebene Zeiteinheit, beispielsweise 15 min, integriert wird, und der jeweils höchste Wert gespeichert. Der dahinter stehende Zweck dieser Vorgangsweise besteht darin, dass der Stromlieferant auch die Bereitstellung der Energie im Tarif berücksichtigen muss, selbst wenn der Bereitstellungsrahmen nicht durchgehend ausgeschöpft wird.

Bekannte Lösungen, um die Überschreitung eines vorgegebenen Höchstwertes bei einer Verbrauchsspitze zu vermeiden, verwenden z.B. einen Höchstlastwächter. Dabei handelt es sich um Verbrauchszähler, die den Stromverbrauch laufend messen und bei einer drohenden Überschreitung einen Alarm auslösen. In einem solchen Fall bleibt es dann dem Betreiber der Verbraucher-Anlage überlassen, den Verbrauch zu reduzieren, z.B. durch Abschalten nicht unbedingt notwendiger Geräte. In weiter entwickelten Lösungen sind die Höchstlastwächter dahin gehend automatisiert, dass sie direkt die vorübergehende Abschaltung eines Teils der Verbraucher-Anlage, beispielsweise nicht-zeitkritische Verbraucher wie etwa ein Warmwasserspeicher, auslösen.

Daneben gibt es auch andere Anwendungsfälle, in denen das Vermeiden bzw. ein Ausgleich von Lastspitzen wichtig ist. Oft tritt der Fall ein, dass in einem Betrieb eine Anlage nur kurzzeitig (z.B. einige wenige Minuten am Tag) eine sehr hohe Leistung benötigt, während ansonsten ein deutlich geringerer Energieverbrauch die Regel ist.

Die EP 1 253 696 A1 beschreibt eine Energieversorgung für eine Last mit vorhersagbaren Lastspitzen, wobei aufgrund eines Signals, das eine Lastspitze ankündigt, eine Batterie zugeschaltet wird, um eine Überbelastung der normalen Speisequelle (PWR) zu vermeiden. Dieses Verfahren setzt die Vorab-Kenntnis der Lastspitzenzeiten voraus und verlangt eine zusätzliche Signalleitung von der Last zur Versorgungssteuerung.

Es ist daher Aufgabe der Erfindung, eine Stromversorgung zur Verfügung zu stellen, die Verbrauchsspitzen abdeckt und so gegenüber dem Versorgungsnetz "kaschiert". Dies soll selbstverständlich automatisch (ohne Eingreifen des Betreibers) und ohne Unterbrechung der Stromversorgung des Verbrauchers oder einzelner Verbraucher-Geräte erfolgen.

Die Aufgabe wird von einer Einrichtung zur Spitzenlastabdeckung der eingangs genannten Art gelöst, bei der die Steuereinrichtung dazu eingerichtet ist, aus dem mithilfe der Messeinrichtung bestimmten Energieverbrauch eine Verbrauchsmenge elektrischer Energie bis zum Ende eines gegebenen Zeitintervalls abzuschätzen und im Falle eines Anstiegs des so erhaltenen Prognosewertes über einen vorgegebenen Schwellenwert den Wechselrichter zur Unterstützung der Versorgung des Verbrauchers in Betrieb zu nehmen.

Durch diese Lösung gelingt eine zuverlässige und verbesserte Überbrückung - oder besser, Ausgleichen - von Lastspitzen des Verbrauchers. Dadurch ist es möglich, den Netzanschluss auf eine geringere Leistung auszulegen, und/ oder einen günstigeren Stromtarif zu erreichen.

Die Erfindung betrifft eine Einrichtung zur Spitzenlastbedeckung nach Anspruch 1.

In einer bevorzugten Ausführungsform der Erfindung kann die durch den Wechselrichter in den Anschlusskreis eingespeiste Energie bzw. Leistung geregelt werden. Die durch den Wechselrichter eingespeiste Leistung kann durch die Steuereinrichtung stufenlose eingestellt werden. Hierfür ist es günstig, wenn die Steuereinrichtung dazu eingerichtet ist, die durch den Wechselrichter eingespeiste Energie auf einen Wert einzustellen, durch den der Energieverbrauch bzw. die Verbrauchsmenge unter dem vorgegebenen Schwellenwert liegt. Insbesondere für den Fall, dass der Energieverbrauch über Messintervalle integriert zur Berechnung des Stromtarifs herangezogen wird, ist eine spezifische Überwachung des Stromverbrauchs zweckmäßig. In einer bevorzugten Variante wird eine lineare Extrapolation zur Abschätzung der Verbrauchsmenge verwendet. Dann erfolgt die Inbetriebnahme des Wechselrichters im Falle, dass die aus der bisherigen Verbrauchsmenge und dem momentanen Energieverbrauch bis zum Ende eines Zeitintervalls linear extrapolierte Verbrauchsmenge elektrischer Energie über einen vorgegebenen Schwellenwert liegen würde.

Weiters kann vorteilhafter Weise für das Laden des Gleichstromspeichers ein aus dem Anschlusskreis des Verbrauchers speisbares Ladegerät vorgesehen sein. Dabei ist es günstig, wenn das Ladegerät von der Steuereinrichtung ein/ausschaltbar ist, und zudem kann die Steuereinrichtung dazu eingerichtet sein, das Ladegerät nur während jener Zeiten einzuschalten, da der Wechselrichter nicht in Betrieb ist.

Es ist überdies vorteilhaft, wenn der Schwellenwert von der Einrichtung selbst bestimmt wird. Zu diesem Zweck kann die Steuereinrichtung dazu eingerichtet sein, den Energieverbrauch des Verbrauchers über eine Verbrauchsperiode zu protokollieren und aus dem so protokollierten Verbrauchsverlauf einen Schwellenwert für die nächste Verbrauchsperiode nach einer vorgegebenen Vorschrift zu ermitteln. Beispielsweise können die Maxima des Verbrauchs in der protokollierten Verbrauchsperiode bestimmt werden, und als neuer Schwellenwert wird jenes Maximum ausgewählt, für das ausgehend vom zeitabhängigen Verbrauch der protokollierten Verbrauchsperiode durch Zuschaltung des Wechselrichters in Spitzenverbrauchszeiten (nämlich wenn der Verbrauch den Wert dieses Maximums übersteigt) eine Absenkung des aus dem Elektrizitätsnetz entnommenen Verbrauchs unter den Wert dieses Maximums möglich ist, ohne dass die Speicherkapazität des Gleichstromspeichers überschritten würde.

Im Folgenden wird die Erfindung samt weiterer Vorzüge anhand eines Ausführungsbeispiels näher erläutert, das in den beigefügten Zeichnungen dargestellt ist. Die Zeichnungen zeigen in schematischer Form:
Fig. 1 ein Blockschaltbild einer Stromversorgung des Ausführungsbeispiels;
Fig. 2 ein Beispiel einer Extrapolation des Energieverbrauchs; und
Fig. 3 ein Ablaufsdiagramm der Steuerung der Stromversorgung der Fig. 1.

Eine bevorzugte Ausführungsform der Erfindung bezieht sich auf die Stromversorgung der elektrischen Geräte eines Imbissladens, z.B. eines Würstelstands. Selbstverständlich ist die Erfindung nicht auf diese Ausführungsform beschränkt; vielmehr stellt sie und ihre Einzelheiten nur ein nicht-einschränkendes Beispiel für die verschiedenen Anwendungsmöglichkeiten der Erfindung dar.

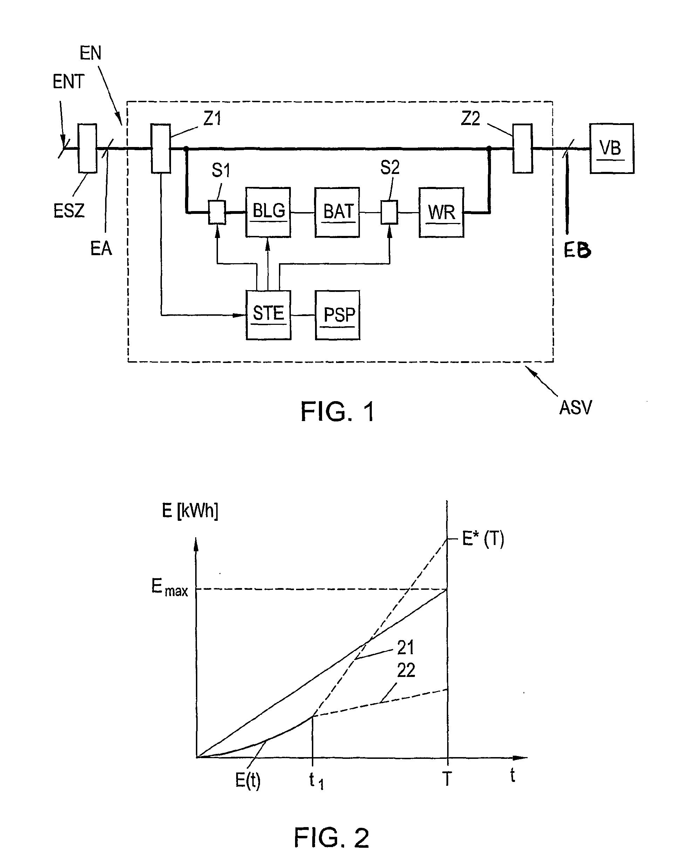

Fig. 1 zeigt ein Blockschaltbild der Stromversorgung des Imbissladens nach der Erfindung. Die elektrischen Geräte des Imbissladens, wie z.B. mehrere Herdplatten mit maximaler Leistungsaufnahme von jeweils 1,5 bis 2 kW sowie verschiedene Warmhalte- und Kühlgeräte, sind summarisch als Verbraucher VB repräsentiert. Die Stromversorgung wird aus dem öffentlichen Elektrizitätsnetz ENT gespeist, das dem Imbissladen einen Anschluss EA zur Verfügung stellt, in dem hier betrachteten Fall ein Anschluss für einen Gewerbebetrieb, ausgelegt auf beispielsweise 10 kW. Die über den Anschluss EA bezogene Strommenge wird nach üblicher Art mit einem integrierenden Stromzähler ESZ gemessen, der Eigentum des Betreibers des Netzes ENT ist und von dem Inhaber des Anschlusses EA (= Betreiber des Imbissladens) nicht manipuliert werden darf.

Der Anschluss EA ist im hier betrachteten Beispiel ein Wechselstrom-1-Phasen-Anschluss (Phase und Null-Leiter); in gleicher Weise sind auch andere Anschlussarten möglich, insbesondere 3-Phasen-Anschlüsse (sogenannter Drehstrom). Die verstärkten Linien in Fig.1 stellen Wechselstromleitungen mit einer passenden Anzahl von Leitern dar.

Die Erfindung soll Verbrauchsspitzen des Verbrauchers VB, die zur einer Überschreitung eines Schwellen- oder Höchstwertes führen würden, durch zusätzliches Einspeisen von Energie begrenzen, z.B. aus einem Speicher wie einer Batterie. Als ein solcher Schwellenwert wird zweckmäßiger Weise - je nach maßgeblichen Tarifmodell - der bisherige Höchstwert angesetzt (oder, falls z.B. der Tarif gestuft ist, jener Wert, der die Schwelle zur nächsten Tarifstufe repräsentiert). Ungeachtet, um welche Art von Verbraucher es sich dabei handelt, soll die Stromversorgung des Verbrauchers bei einem möglichst niedrigen Tarif ermöglicht und gewährleistet werden.

Gemäß der Erfindung ist zwischen dem Verbraucher VB und dem Netzanschluss EA eine Anlage ASV ("Ausgleichende Stromversorgung") geschaltet, deren Hauptaufgabe das Ausgleichen von Leistungsspitzen des Verbrauchers VB ist. Die grundsätzliche Funktion der Anlage ASV entspricht einer unterbrechungsfreien Stromversorgung für Wechselspannung, jedoch mit dem Unterschied, dass sie gerade bei bestehender Netzversorgung Elektrizität einspeist, und nicht (oder nicht nur) bei einem Ausfall der Netzversorgung.

In der erfindungsgemäße Anlage ASV erfasst eine Steuereinheit STE ständig den Verbrauch der Anlage mithilfe eines integrierenden Stromzählers Z1, der eingangsseitig die bezogene Energie misst. Der Stromverbrauch wird jeweils über gleiche Zeit-Intervalle integriert, wie dies seitens des Verbrauchszählers ESZ des Elektrizitätsnetzes ENT geschieht. Weiters sind eine Batterie BAT (oder eine andere geeignete Einrichtung zum reversiblen Speichern von Energie) und ein Wechselrichter WR vorgesehen.

Die Batterie BAT ist als reversibler Gleichstromspeicher für einen Energieinhalt ausgelegt, der zumindest so groß ist, um einen Teil der Spitzenlast der Anlage für zumindest eine Integrationsperiode zu liefern; freilich hängt es von der jeweils gegebenen Anwendungssituation ab, welche Batteriegröße angemessen und sinnvoll ist. In dem hier betrachteten Beispiel ist die Batterie BAT eine Anordnung von Blei-Akkumulatoren mit einer gesamten Strommenge von ca. 150 Ah bei einer Batteriespannung von ca. 36 V; mit dieser Wahl können ein bis zwei Herdplatten (ca. 2 kW) über eine Stunde hinweg zuverlässig versorgt werden. Für die hier gewählte Spannung kann günstiger Weise eine Kraftfahrzeug-Batterie bzw. Kombinationen solcher Batterien eingesetzt werden.

Die Batterie wird mittels eines handelsüblichen Batterie-Ladegeräts BLG mit der erforderlichen Gleichspannung versorgt, wobei die Leistungsaufnahme des Ladegeräts BLG im Vergleich zum Verbraucher VB gering ist. Beispielsweise ergibt sich für ein Batterieladegerät, das für ein Laden der Batterie mit 36 V / 150 Ah über Nacht ausgelegt ist (z.B. für 15 A bei 36 V), eine Nennleistung von ca. 550 W.

Der Wechselrichter WR ist auf eine Anschlussspannung ausgelegt, die der Batteriespannung entspricht, und dient der Umwandlung der von der Batterie gelieferten Gleichspannung in eine Wechselspannung entsprechend den Parametern des Netzanschlusses. Wechselrichter-Geräte dieser Art sind wohlbekannt.

Das Laden der Batterie BAT (= Aktivierung des Ladegeräts BLG und Ausschalten des Wechselrichters WR) einerseits, sowie das Rückspeisen (= Aktivierung des Wechselrichters WR) andererseits werden von der Steuereinrichtung STE mittels Schalter S1 und S2 gesteuert, wie im Folgenden beschrieben. Gegebenenfalls können die Schalter S1 und/oder S2 auch in dem Ladegerät BLG bzw. dem Wechselrichter WR integriert realisiert sein, insbesondere wenn das betreffende Gerät eine elektronische Ansteuerung zulässt.

Die Steuereinheit STE ist beispielsweise mithilfe eines Mikroprozessors realisiert, der die Integration des Stromverbrauchs nach Art des netzeigenen Stromzähler durchführt und die so erhaltenen Werte zusammen mit dem zugehörenden Zeitpunkt speichert, z.B. in einem Permanent-Speicher PSP auf Festplatte oder auswechselbarer Diskette. Außerdem erstellt er aufgrund des aktuellen Stromverbrauchs eine Prognose (siehe unten zu Fig. 2) über den Summenwert am Ende der gerade laufenden Integrationsperiode. Die Steuereinheit erhält so eine Abschätzung (Voraussage), ob in der gerade laufenden Integrationsperiode eine Überschreitung eines Schwellenwertes droht, insbesondere eines früher gemessenen Tarif-Höchstwertes. Ist dies der Fall, d.h. ist eine Überschreitung zu befürchten, wird der Wechselrichter eingeschaltet, der somit aus der Batterie Energie in den (lokalen) Anschlusskreis EN des Verbrauchers rückspeist. Zweckmäßiger Weise sollte zugleich das Ladegerät BLG abgeschaltet werden, um einen "Energie-Kreislauf" mit den damit verbundenen Verlusten zu vermeiden; außerdem trägt dies zusätzlich zur Verringerung der aktuellen Verbrauchsleistung bei. Dadurch wird ein Teil der am Anschluss EA angeschlossenen Verbraucher VB von der Batterie BAT mitversorgt, und die aus dem Netz ENT aufgenommene Leistung sinkt. Auf diese Weise wird ein Überschreiten eines früheren Höchstwertes und somit eine Erhöhung des Stromtarifs vermieden.

Um den Datenspeicher nicht unnötig zu füllen, löscht die Steuereinheit STE alle Werte zwischen zwei Höchstständen, da solche Verbrauchswerte auch für spätere Auswertungen (z.B. zu Kontrollzwecken) keine weitere Bedeutung haben.

Zweckmäßiger Weise können die Batterie BAT und das zugehörende Ladegerät BLG extern zur Stromversorgungsanlage ASV ausgeführt sein, um eine leichtere Anpassung der gesamten Anlage an die jeweils gegebenen Bedingungen am Ort des Verbrauchers VB zu ermöglichen.

Anstelle oder zusätzlich zum Stromzähler Z1 kann ein zweiter Stromzähler Z2 bei dem verbraucherseitigen Anschluss EB vorgesehen sein, der ausgangsseitig die dem Verbraucher VB gelieferten Energiemenge misst. Grundsätzlich können auch mehrere Verbraucher angeschlossen werden; am Einfachsten geschieht dies durch Parallelschaltung der Verbraucher zum einem "Gesamtverbraucher", der an Stelle des Verbrauchers VB der Fig.1 tritt.

Es sei angemerkt, dass als Alternative zur erfindungsgemäßen Lösung selbstverständlich möglich ist, bestimmte Verbraucher über eine Unterbrechungsfreie Stromversorgung (USV) mit Batterie-Pufferung zu betreiben und bei Ansprechen des Höchstlast-Warners die Netzversorgung der USV zu unterbrechen und die Verbraucher über eine kurze Zeit über die Batterien zu versorgen. Diese Lösung hat den Nachteil, dass im Vorhinein bestimmt werden muss, welche Verbraucher über die USV zu versorgen sind; eine unterstützende Einspeisung in das (in Betrieb befindliche) Stromnetz ist mit der USV nicht möglich. Bei der erfindungsgemäßen Lösung wird auf der Verbraucherseite des Stromzählers direkt in den Anschlusskreis EN eingespeist, und die vom Elektrizitätsnetz ENT zugeführte Leistung folglich um die gesamte eingespeiste Leistung aus dem Batterie-gespeisten Umformer, nämlich dem Wechselrichter WR, reduziert. Als Umformer können auf vorteilhafte Weise auch Wechselrichter an, die ursprünglich für die Einspeisung elektrischer Energie aus photovoltaischen Anlagen ins öffentliche elektrische Netz ausgelegt sind. Diese Wechselrichter verfügen bereits über sämtliche Sicherheitseinrichtungen, die für einen sicheren Einspeisbetrieb nötig sind, insbesondere hinsichtlich der Auflagen der Netzbetreiber, wie z.B. eine Netzsparmungserkennung, die bei Wegfall des Netzes (z.B. infolge Wartungsarbeiten) selbstständig die Einspeisung beenden (um ein gefahrloses Arbeiten der Wartung zu ermöglichen).

Falls die Gleichspannung der Batterie BAT und die Einspeisspannung für den Umformer (Wechselrichter WR) verschieden sind, - beispielsweise, weil die Batteriespannung auf ein ungefährliches Kleinspannungs-Niveau gehalten werden soll, - kann durch Zwischenschalten eines Gleichspannungswandlers (DC-DC-Wandler) die für den Betrieb des Umformers nötige Eingangsspannung erzeugt werden. Umgekehrt kann, wenn die Ausgangsspannung des Wechselrichters WR nicht der Spannung des Netzes ENT,EN entspricht, ein 50 Hz-Leistungstransformator dem Wechselrichter nachgeschaltet werden.

Fig. 2 illustriert die lineare Prognose der Steuereinheit STE an einem Fallbeispiel. In der Steuereinheit STE wird, wie bereits erwähnt, der momentane Verbrauch ab Beginn der aktuellen Integrationsperiode laufend integriert und so die bisher (im aktuellen Zeitintervall) verbrauchte Energie E(t) ermittelt. Fig. 2 zeigt eine solche Darstellung der Verbrauchsmenge E(t) (gemessen z.B. in kWh) als Funktion der Zeit t, wobei lediglich die gerade aktuelle Integrationsperiode gezeigt wird, die bei t=0 beginnt und bei t=T endet. T ist die Periodendauer, z.B. 15 min. Auch gezeigt ist der derzeit geltende Schwellenwert Eₘₐₓ (früherer Verbrauchs-Höchstwert), der möglichst nicht überschritten werden soll. Zu jedem Prüfzeitpunkt t₁ (z.B. in Abständen von 10 s oder 1 min) wird der momentane Verbrauch - der als Leistung einer Steigung im Diagramm entspricht - linear bis zum Ende der Integrationsperiode extrapoliert (obere gebrochene Linie 21). Hierbei wird der Verbrauch ohne Zuschaltung des Wechselrichters, also ohne Rückspeisung, zugrunde gelegt. Der sich so ergebende Wert E*(T) wird mit dem Schwellenwert Eₘₐₓ verglichen. Falls der Wert E*(T) - wie im Beispiel der Fig. 2 - über Eₘₐₓ liegt, droht eine Überschreitung und der Wechselrichter wird zugeschaltet. Auf diese Weise ergibt sich ein deutlich geringerer Verbrauch, bei dem keine Überschreitung zu befürchten ist (untere gebrochene Linie 22).

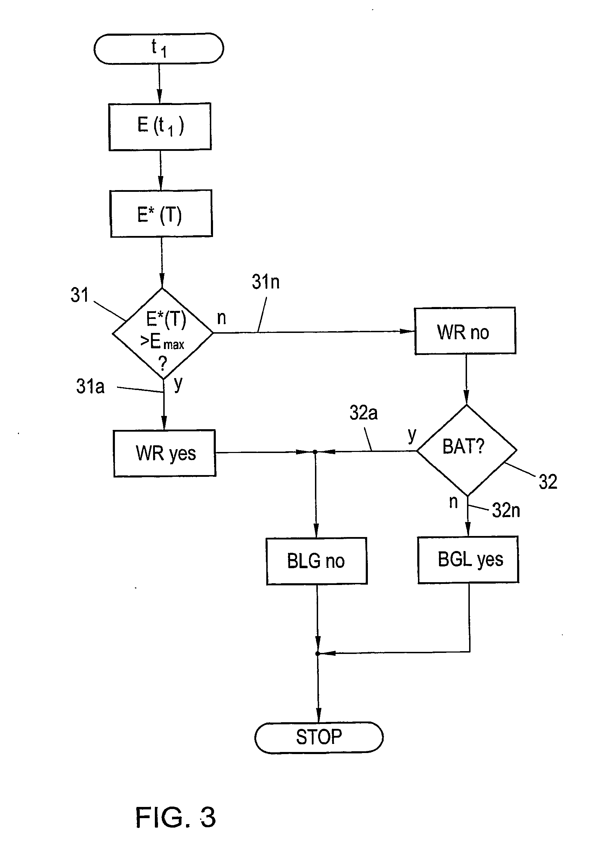

Der Ablauf der Steuerung ist in dem Ablaufdiagramm der Fig. 3 dargestellt, das zu jedem Prüfzeitpunkt t₁ durchlaufen wird. Als erster Schritt wird mittels des integrierenden Zählers Z1 die soweit aufgelaufene Verbrauchsmenge E(t₁) bestimmt. Sodann wird die lineare Prognose für E*(T) erstellt; ist zu diesem Zeitpunkt die Rückspeisung bereits aktiv, wird die Prognose für E*(T) für die Situation erstellt, wenn die Rückspeisung abgeschaltet würde. In der Entscheidung 31 wird geprüft, ob der so gewonnene Wert E*(T) größer als der Schwellenwert Eₘₐₓ ist; in Abhängigkeit von dem Prüfergebnis wird mit dem Zweig 31a oder 31n fortgesetzt. Ist E*(T) größer als Eₘₐₓ (Zweig 31a), wird der Wechselrichter aktiviert (bzw. verbleibt im aktiven Zustand) und somit Energie rückgespeist, und das Batterieladegerät wird abgeschaltet. Über Zweig 31n jedoch - wenn E*(T) unter Eₘₐₓ liegt - wird der Wechselrichter abgeschaltet (bzw. verbleibt im passiven Zustand). Sodann wird in Entscheidung 32 der Ladezustand der Batterie BAT geprüft. Ist der Ladezustand ausreichend, so wird über den Zweig 32a fortgesetzt und das Ladegerät BLG wird deaktiviert; anderenfalls wird - Zweig 32n - das Ladegerät BLG eingeschaltet, um die Batterie BAT aufzuladen.

Die Erfindung eignet sich besonders für Verbraucher-Anlagen im einstelligen kW-Bereich, wobei als besonderer Vorteil der Erfindung auch Wechselrichter bekannter Art verwendet werden können. Insbesondere können für den Einsatz in Solaranlagen konzipierte Wechselrichter, wie z.B. ein SITOP-Gerät der Anmelderin, verwendet werden, die ebenfalls für die Einspeisung von Wechselstrom in ein Wechselstromnetz während dessen Betrieb ausgelegt sind.

Die spitzenausgleichende Stromversorgung ASV vermeidet nicht nur weitere Stromverbrauchs-Höchststände; vielmehr ist sie - in einer erweiterten Variante des obigen Ausführungsbeispiels - auch geeignet, den Energieverbrauch generell zu auszugleichen, sodass nur noch geringere Integrationswerte entstehen und durch Mittelung des Netzstromverbrauchs ein günstiger Netztarif erreicht wird und folglich die Stromrechnung sinkt. Ausgehend von der Annahme, dass Tag für Tag ähnliche Verbrauchsprofile auftreten, kann die Steuerung ermitteln, wann die (natürlich begrenzte) Batteriekapazität und Einspeiseleistung am Effektivsten eingesetzt werden kann. Im hier betrachteten Beispiel ist angenommen, dass die zu vergleichenden Verbrauchsperioden Tage sind, was im Falle des erwähnten Imbissladens (oder ähnlichem Gewerbebetrieb) in der Regel zutrifft; bei anderen Anwendungsfällen ist gegebenenfalls anstelle des Tages als Verbrauchsperiode eine entsprechend angepasste Periode von z.B. 24 h, 48 h oder 168 h Dauer einzusetzen. Die Verbrauchsperiode ist jedoch keinesfalls mit der Integrationsperiode T zu verwechseln; vielmehr erstreckt sich die Verbrauchsperiode über eine Vielzahl von Integrationsperioden.

In dieser Erweiterung ist seitens der Steuereinheit STE eine selbstlernende Anwendung eingerichtet, die über einen gesamten Tag hinweg den (von einem Spitzenausgleich unbeeinflussten) Verbrauch misst und speichert, z.B. in Form der Verbrauchsmengen, die für aufeinanderfolgende Integrationsintervalle T mit dem integrierenden Zähler Z1 gemessen wurden. Der auf diese Weise protokollierte Verbrauchsverlauf eines Tages wird unter Berücksichtigung der Batteriekapazität als Grundlage für einen Ausgleich des Energieverbrauchs verwendet. Aus dem Verbrauchsprofil werden die höchsten Verbrauchswerte (genauer: Verbrauchsmengenwerte) bestimmt. Zuerst wird die Differenz zwischen dem höchsten Verbrauchswert und dem zweithöchsten berechnet. Sodann wird die Batterieentladung kalkuliert, die sich ergibt, wenn durch Zuspeisen im dem Höchstwert zugeordneten Integrationsintervall der Verbrauch auf den zweithöchsten Verbrauchswert gesenkt wird. Dieser erster Durchlauf der Kalkulation ergibt einen ersten Batterie-Endstand. Im nächsten Durchlauf wird berechnet, welcher zweiter Batterie-Endstand sich ergibt, wenn der Verbrauch in den beiden höchsten Integrationsintervallen durch Zuspeisen auf den Wert des dritthöchsten Verbrauchs gesenkt würde. Ergibt sich ein positiver zweiter Batteriestand (größer als 0), kann ein dritter Durchlauf durchgeführt werden, bei dem ein dritter Batterie-Endstand berechnet wird, der nach Zuspeisen in den drei höchsten Integrationsintervallen zum Absenken auf den vierthöchsten Verbrauchswert erreicht wird. Diese Durchläufe werden so lange iteriert, bis die Batteriekapazität erschöpft ist. Der zuletzt erfolgreich erreichte Verbrauchswert (d.h. mit positivem zugeordneten Batterie-Endstand) wird dann während des nächsten Tags als Schwellenwert Eₘₐₓ verwendet.

Da die Zeiten der betreffenden Intervalle bekannt sind, kann zusätzlich das Aufladen der Batterie BAT in den Zeiträumen zwischen den Integrationsintervallen, in denen nach dem obigen Verfahren in den Verbraucher-Anschlusskreis EN zugespeist wird, berücksichtigt werden. Dabei muss außerdem beachtet werden, dass die Energiebilanz durch Ladeverluste einen Wirkungsgrad unterhalb 100% hat - z.B. bei Bleiakkus etwa 80 bis 85 % (durch chemische Verluste und Verluste im Ladegerät BLG).

Die Auswertung kann selbstverständlich auch für mehrere Tage (Verbrauchsperioden) berechnet werden, deren Verbrauchsverläufe gespeichert wurden. Es wird dann für jeden Tag ein (vorläufiger) Schwellenwert erhalten, aus denen der endgültige Schwellenwert z.B. durch Auswahl des größten der (vorläufigen) Schwellenwerte, Auswahl des Medianwerts oder eine Mittelungsprozedur gewonnen wird.

Auch im aktiven Betrieb auf der Grundlage des Verbrauchs-Ausgleichs erfolgt weiterhin eine Protokollierung des Tagesverbrauchs, der dann für eine neuerliche Berechnung des Schwellenwerts Eₘₐₓ herangezogen wird, mit dem Ziel, auf Verbrauchsänderungen - wie z.B. saisonale Schwankungen - angemessen reagieren zu können.

Darüber hinaus kann vorgesehen sein, dass der Benutzer vorab bekannte Änderungen im Stromverbrauch - z.B. wenn ein weiteres Verbrauchergerät hinzu kommt - der Steuereinheit eingeben kann; hierfür ist der Steuereinheit eine Ein/Ausgabe EAE zugeordnet. Hierbei werden die Daten über den voraussichtlichen Verbrauch und voraussichtliche Einschaltzeit und Verbrauchsdauer eingegeben; diese werden dem gemessenen Verbrauchsverlauf aufgeschlagen und der so erhaltene Verbrauchsverlauf dem oben beschriebenen Berechnungsverfahren zugrunde gelegt.

Eine andere zweckmäßige Erweiterung betrifft die Steuerung des Ladestroms der Batterie BAT. Im oben beschriebenen Beispiel wird die Batterie BAT immer dann geladen, wenn die volle Batteriekapazität noch nicht erreicht ist und eine Überschreitung des Verbrauch-Schwellenwerts Eₘₐₓ nicht droht. In einer Variante kann der Ladevorgang auf bestimmte Zeiten eingeschränkt werden, die vom Benutzer über die Ein/Ausgabe EAE eingegeben werden können, z.B. nur auf Nachtzeiten (Nachtstromtarif) oder auf die Ruhezeit des Imbissladens. In einer anderen Variante (oder in Kombination mit der vorigen Variante) kann die Steuereinheit STE, beispielsweise über eine Ansteuerung des Ladegeräts BLG, den Ladestrom der Batterie bzw. die Energieaufnahme des Ladegeräts BLG bei Bedarf beschränken; nämlich wenn eine Überschreitung droht, und zwar soweit, dass der Schwellenwert Eₘₐₓ wieder eingehalten wird. In diesem Fall erfolgt eine Zuspeisung aus der Batterie BAT über den Wechselrichter WR erst dann, wenn die Reduktion des Ladestroms nicht ausreicht, um den Verbrauch (einschließlich Ladeleistung) unter den Schwellenwert abzusenken.

Es sei angemerkt, dass die Erfindung sich auch für jene Fälle eignet, in denen die Tarifmodelle zeitabhängig sind. Hierzu berücksichtigt die Steuereinheit STE zusätzlich die verschiedenen Tarifstrukturen zu verschiedenen Zeiten, z.B. dadurch, dass bei der Prognose die Energie-Werte mit dem Strompreis (z.B. EUR/kWh) multipliziert werden; in Fig. 2 würde dann anstelle der verbrauchten Energiemenge ein Kostenverbrauch erscheinen.

Es sei angemerkt, dass anstelle der Batterie BAT, die als reversibler Gleichstromspeicher dient, auch eine andere Gleichstromquelle verwendet werden kann. Beispielsweise kann auch ein Diesel- oder Benzin-getriebener Generator eingesetzt werden, der im Bedarfsfall von der Steuereinheit gestartet wird und eine Gleichspannung liefert, die dem Eingang des Wechselrichters zugeführt wird. Dies hat gegenüber dem direkten Einspeisen aus dem Generator in den Anschlusskreis den Vorteil, dass im Sinne der Erfindung ein stufenloses Einspeisen zusätzlicher elektrischer Energie gelingt.

Noch eine andere Erweiterung der Erfindung wird mittels einer Empfängereinheit beispielsweise in Form eines Rundsteuerempfängers RSE realisiert, der an die Steuereinheit STE angeschlossen ist und über den von dem Betreiber des öffentlichen Netzes ENT die Rückspeisung von Energie unabhängig vom Energieverbrauch des Verbrauchers ausgelöst werden kann. Dadurch kann in das Netz ENT, insbesondere wenn dort Verbrauchsspitzen auftreten, aus der Batterie BAT elektrische Energie zurückgespeist werden, was in der Regel auf der Basis eines höheren Tarifes erfolgt.

## Patentansprüche

1. Einrichtung zur Spitzenlastabdeckung eines an einen Wechselstromanschluss eines öffentlichen Elektrizitätsnetzes (ENT) anschließbaren elektrischen Verbrauchers (VB), mit einem Wechselrichter (WR), der aus einem Gleichstromspeicher (BAT) speisbar und mit seinem Ausgang an die Elektrizitätsversorgung (EB) des Verbrauchers (VB) parallel anschließbar ist,
einer in den Anschlusskreis (EN) des Verbrauchers schaltbare Messeinrichtung (Z1, Z2) und
einer Steuereinrichtung (STE), die dazu eingerichtet ist, mithilfe der Messeinrichtung (Z1,Z2) den Energieverbrauch des Verbrauchers (VB) zu überwachen und im Falle eines Anstiegs des so erhaltenen Energieverbrauchswertes über einen vorgegebenen Schwellenwert den Wechselrichter (WR) zur Unterstützung der Versorgung des Verbrauchers in Betrieb zu nehmen,
**dadurch gekennzeichnet, dass**
die Steuereinrichtung (STE) dazu eingerichtet ist, aus dem Energieverbrauch des Verbrauchers (VB) eine Verbrauchsmenge elektrischer Energie (E*(T)) bis zum Ende (T) eines gegebenen Zeitintervalls abzuschätzen und im Falle eines Anstiegs des so erhaltenen Prognosewertes über einen vorgegebenen Schwellenwert (Eₘₐₓ) den Wechselrichter (WR) zur Unterstützung der Versorgung des Verbrauchers in Betrieb zu nehmen.

2. Einrichtung nach Anspruch 1, **dadurch gekennzeichnet, dass** die Steuereinrichtung (STE) dazu eingerichtet ist, mithilfe der Messeinrichtung (Z1, Z2) den Energieverbrauch des Verbrauchers (VB) zu überwachen und im Falle, dass die aus der bisherigen Verbrauchsmenge und dem momentanen Energieverbrauch bis zum Ende eines Zeitintervalls linear extrapolierte Verbrauchsmenge elektrischer Energie (E*(I)) über einen vorgegebenen Schwellenwert (Eₘₐₓ) liegen würde, den Wechselrichter (WR) zur Unterstützung der Versorgung des Verbrauchers in Betrieb zu nehmen.

3. Einrichtung nach Anspruch 1 oder 2, **dadurch gekennzeichnet, dass** die Steuereinrichtung dazu eingerichtet ist, die durch den Wechselrichter eingespeiste Energie auf einen Wert einzustellen, durch den der Energieverbrauch bzw. die Verbrauchsmenge unter dem vorgegebenen Schwellenwert liegt.

4. Einrichtung nach einem der Ansprüche 1 bits 3, **gekennzeichnet durch** ein aus dem Anschlusskreis (EN) des Verbrauchers (VB) speisbares Ladegerät (BLG) für das Laden des Gleichstromspeichers (BAT).

5. Einrichtung nach Anspruch 4, **dadurch gekennzeichnet, dass** das Ladegerät (BLG) von der Steuereinrichtung (STE) ein/ ausschaltbar ist.

6. Einrichtung nach Anspruch 5, **dadurch gekennzeichnet, dass** die Steuereinrichtung (STE) dazu eingerichtet ist, das Ladegerät nur während jener Zeiten einzuschalten, da der Wechselrichter (WR) nicht in Betrieb ist.

7. Einrichtung nach einem der Ansprüche 1 bis 6, **dadurch gekennzeichnet, dass** die Steuereinrichtung dazu eingerichtet ist, den Energieverbrauch des Verbrauchers (VB) über eine Verbrauchsperiode zu protokollieren und aus dem so protokollierten Verbrauchsverlauf einen Schwellenwert für die nächste Verbrauchsperiode nach einer vorgegebenen Vorschrift zu ermitteln.

8. Einrichtung nach Anspruch 7, **dadurch gekennzeichnet, dass** für die Ermittlung des Schwellenwerts für die nächste Verbrauchsperiode vorgesehen ist, die Maxima des Verbrauchs in der protokollierten Verbrauchsperiode zu bestimmen, und als neuen Schwellenwert jenes Maximum auszuwählen, für das ausgehend vom zeitabhängigen Verbrauch der protokollierten Verbrauchsperiode durch Zuschaltung des Wechselrichters (WR) in Spitzenverbrauchszeiten eine Absenkung des aus dem Elektrizitätsnetz (ENT) entnommenen Verbrauchs unter den Wert dieses Maximums möglich ist, ohne dass die Speicherkapazität des Gleichstromspeichers (BAT) überschritten würde.

9. Einrichtung nach einem der Ansprüche 1 bis 8, **gekennzeichnet durch** eine Empfängereinrichtung (RSE), der mit der Steuereinrichtung (STE) verbunden ist, und über den die Einspeisung von Energie **durch** den Wechselrichter (WR) unabhängig vom Energieverbrauch des Verbrauchers (VB) auslösbar ist.

## Claims

1. Device for covering the peak load requirements of an electrical load (VB) which can be connected to an alternating current terminal of a public electricity supply network (ENT), the device comprising a power inverter (WR) which can be fed from a direct-current accumulator (BAT) and which by means of its output can be connected in parallel to the electricity supply (EB) of the load (VB),
a measuring device (Z1, Z2) which can be incorporated into the connection circuit (EN) of the load and a control device (STE) which is configured for monitoring the energy consumption of the load (VB) with the aid of the measuring device (Z1, Z2) and, in the event that the energy consumption value obtained in this manner exceeds a predefined threshold value, for putting the power inverter (WR) into operation in order to support the supply to the load,
**characterised in that**
the control device (STE) is configured for estimating, from the energy consumption of the load (VB), a quantity of electrical energy (E*(T)) that has been consumed up to the end (T) of a given time interval and, in the event that the forecast value obtained in this manner exceeds a predefined threshold value (Eₘₐₓ), for putting the power inverter (WR) into operation in order to support the supply to the load.

2. Device according to claim 1, **characterised in that** the control device (STE) is configured for monitoring the energy consumption of the load (VB) with the aid of the measuring device (Z1, Z2) and, in the event that the quantity of consumed electrical energy (E*(T)) that has been obtained by linear extrapolation from the previous consumption quantity and the instantaneous energy consumption up to the end of a time interval were to exceed a predefined threshold value (Eₘₐₓ), putting the power inverter (WR) into operation in order to support the supply to the load.

3. Device according to claim 1 or 2, **characterised in that** the control device is configured for setting the energy that is fed in by the power inverter to a value that results in the energy consumption or the consumption quantity being less than the predefined threshold value.

4. Device according to one of claims 1 to 3, **characterised by** a charger device (BLG) which is provided for charging the direct-current accumulator (BAT) and which can be fed from the connection circuit (EN) of the load (VB).

5. Device according to claim 4, **characterised in that** the charger device (BLG) can be switched on/off by the control device (STE).

6. Device according to claim 5, **characterised in that** the control device (STE) is configured for switching on the charger device only during those times when the power inverter (WR) is not in operation.

7. Device according to one of claims 1 to 6, **characterised in that** the control device (STE) is configured for logging the energy consumption of the load (VB) over a consumption period and from the consumption curve logged in this manner calculating a threshold value for the next consumption period according to a predefined rule.

8. Device according to claim 7, **characterised in that** in order to calculate the threshold value for the next consumption period it is provided to determine the consumption maxima in the logged consumption period and to select as the new threshold value that maximum for which, based on the time-dependent consumption of the logged consumption period, a reduction in the consumption drawn from the electricity network (ENT) below the value of said maximum is possible by switching on the power inverter (WR) at times of peak consumption without the storage capacity of the direct-current accumulator (BAT) being exceeded.

9. Device according to one of claims 1 to 8, **characterised by** a receiver device (RSE) which is connected to the control device (STE) and via which the feeding-in of energy by means of the power inverter (WR) can be triggered independently of the energy consumption of the load (VB).

## Revendications

1. Dispositif pour couvrir la charge de pointe d'un consommateur (VB) électrique pouvant être raccordé à une borne de courant alternatif d'un réseau (ENT) public d'électricité, comprenant
un onduleur ( WR ) qui peut être alimenté par un accumulateur ( BAT ) de courant continu et qui peut être raccordé en parallèle par sa sortie à l'alimentation ( EB ) en électricité du consommateur ( VB ),
un dispositif ( Z1, Z2 ) de mesure, pouvant être branché dans le circuit ( EN ) de connexion du consommateur, et un dispositif ( STE ) de commande, qui est conçu pour contrôler à l'aide du dispositif ( Z1, Z2 ) de mesure la consommation d'énergie du consommateur ( WB ) et, dans le cas d'une augmentation de la valeur de la consommation d'énergie ainsi obtenue, au-delà d'une valeur de seuil prescrit, pour mettre en fonctionnement l'onduleur ( WR ) afin de soutenir l'alimentation du consommateur,
**caractérisé en ce que**
le dispositif ( STE ) de commande est conçu pour évaluer, à partir de la consommation d'énergie du consommateur ( VB ), une quantité consommée d'énergie ( E*( T ) ) électrique jusqu'à la fin d'un intervalle de temps prescrit et, dans le cas d'une augmentation de la valeur pronostiquée ainsi obtenue, au-delà d'une valeur ( Eₘₐₓ ) de seuil prescrit, pour mettre en fonctionnement l'onduleur ( WR ) pour favoriser l'alimentation du consommateur.

2. Dispositif suivant la revendication 1, **caractérisé en ce que** le dispositif ( STE ) de commande est conçu pour contrôler, à l'aide du dispositif ( Z1, Z2 ) de mesure, la consommation d'énergie du consommateur ( VB ) et, dans le cas où la quantité consommée d'énergie ( E*( T ) ) électrique, extrapolée linéairement à partir de la quantité consommée jusqu'ici et de la consommation d'énergie instantanée, serait supérieure à une valeur ( Eₘₐₓ ) de seuil prescrit, mettre en fonctionnement l'onduleur ( WR ) pour soutenir l'alimentation du consommateur.

3. Dispositif suivant la revendication 1 ou 2, **caractérisé en ce que** le dispositif de commande est conçu pour régler l'énergie injectée par l'onduleur à une valeur à laquelle la consommation d'énergie ou la quantité consommée est inférieure à la valeur de seuil prescrit.

4. Dispositif suivant l'une des revendications 1 à 3, **caractérisé par** un appareil ( BLG ) de charge, qui peut être alimenté à partir du circuit ( EN ) de connexion du consommateur ( VB ) et qui est destiné à charger l'accumulateur ( BAT ) de courant continu.

5. Dispositif suivant la revendication 4, **caractérisé en ce que** l'appareil ( BLG ) de charge peut être branché/débranché par le dispositif ( STE ) de commande.

6. Dispositif suivant la revendication 5, **caractérisé en ce que** le dispositif ( STE ) de commande est conçu pour brancher l'appareil de charge seulement pendant le temps où l'onduleur ( WR ) n'est pas en fonctionnement.

7. Dispositif suivant l'une des revendications 1 à 6, **caractérisé en ce que** le dispositif de commande est conçu pour faire un compte rendu de la consommation d'énergie du consommateur ( VB ) sur un laps de temps de consommation et déterminer à partir de la variation de consommation, dont on a fait ainsi le compte rendu, une valeur de seuil pour le laps de temps suivant de consommation, suivant une prescription prescrite.

8. Dispositif suivant la revendication 7, **caractérisé en ce qu'**il est prévu, pour la détermination de la valeur de seuil pour le laps de temps de consommation suivant, de déterminer les maximums de la consommation dans le laps de temps de consommation dont on a fait un compte rendu et de choisir, comme nouvelle valeur de seuil, le maximum pour lequel, à partir de la consommation en fonction du temps du laps de temps de consommation dont on a fait le compte rendu par connexion de l'onduleur ( WR ) dans des temps de consommation de pointe, est possible un abaissement de la consommation prélevée du réseau ( ENT ) d'électricité en dessous de la valeur de ce maximum, sans que la capacité d'accumulation de l'accumulateur ( BAT ) de courant continu soit dépassée.

9. Dispositif suivant l'une des revendications 1 à 8, **caractérisé par** un dispositif ( RSE ) de récepteur, qui est relié au dispositif ( STE ) de commande et par lequel l'injection d'énergie par l'onduleur ( WR ) peut être déclenchée indépendamment de la consommation d'énergie du consommateur ( VB ).
